# EUROPEAN PATENT SPECIFICATION

(11) **EP 3 885 821 B1**
(45) Date of publication and mention of the grant of the patent: **30.11.2022**
(21) Application number: 20172433.3
(22) Date of filing: 30.04.2020
(51) Int. Cl.: G02F 1/1333, H04N 9/31, H05K 7/20

(54) **DISPLAY DEVICE WITH HEAT EXCHANGE MODULE AND HEAT EXCHANGE METHOD THEREOF**
ANZEIGEVORRICHTUNG MIT WÄRMEAUSTAUSCHMODUL UND WÄRMEAUSTAUSCHVERFAHREN DAFÜR
DISPOSITIF D'AFFICHAGE COMPORTANT UN MODULE D'ÉCHANGE DE CHALEUR ET SON PROCÉDÉ D'ÉCHANGE DE CHALEUR

(30) Priority: 25.03.2020 CN 202010218764
(43) Date of publication of application: 29.09.2021
(73) Proprietor: Keewin Display Co., Ltd., Shanghai 200086 (CN)
(72) Inventor: ZHANG, Qianzhong, Shanghai, Shanghai 200086 (CN); LI, Wen, Shanghai, Shanghai 200086 (CN); ZHOU, Feng, Shanghai, Shanghai 200086 (CN)
(74) Representative: dompatent von Kreisler Selting Werner - Partnerschaft von Patent- und Rechtsanwälten mbB

(56) References cited:
- EP-A1- 3 040 766
- CN-U- 205 681 747
- CN-U- 207 457 921
- US-A1- 2018 088 368
- US-A1- 2019 182 981

## Description

### BACKGROUND

### Technical Field

The present invention relates to the technical field of display devices, and in particular to a display device with a heat exchange module and a heat exchange method thereof.

### Related Art

Due to heating of electronic components per se of a display device in a working process and heat radiation of sunlight through glass, the display device has a high temperature after operating for a period of time, and damage to the electronic components is easily caused if heat dissipation treatment is not performed in time.

The existing display device is generally provided with a heat dissipation structure so as to perform temperature lowering treatment on the display device. Generally, the heat dissipation structure uses a fan or an air conditioner, wherein the heat dissipation effect of the air conditioner is better, but the air conditioner also has a greater size, higher noise, higher power consumption and poorer environment-friendly benefits. Therefore, the fan is commonly used in the heat dissipation of the display device. A prior patent (with the patient application number of 201620556677.8 and the tile of Sealed Display Terminal) of the inventor discloses a sealed display terminal, a sealed space is formed inside the display terminal, a display module is arranged in the sealed space, and a circulation airflow is formed in the sealed space to perform heat dissipation on the display module. Further, in the technical solution, heat dissipation fins are also arranged on a casing so as to perform an inside and outside heat exchange effect for lowering the temperature inside the sealed space. However, the heat dissipation capability of the heat dissipation fins can only meet general display function modules, and the heat dissipation effect on high-power component expansion (such as PC and cameras) is limited. Therefore, there is an urgent need to provide a technical solution with a better heat dissipation effect. In the related prior art, there are a lot of published information discussing the display device with a heat exchange module such as US 2018088368, EP 3040766, US 201982981, CN 205681747 and CN 207457921, in which the US 2018088368 discloses multiple baffles (fins 53) transversely formed in the space, which are in 90 degrees to the airflow. Having baffles in the airflow disturbs the air flow within the space and easily brings pollutants into the space and the pollutants might easily accumulate on top of each of the baffles, which may hinder heat conduction and deteriorate heat dissipation to the entire module.

### SUMMARY

Aiming at overcoming the defects in the prior art, the present invention provides a display device with a heat exchange module and a heat exchange method thereof to solve the problem that in an existing fan heat dissipation solution, the heat dissipation effect of heat dissipation fins on high-power components is limited.

The technical solutions for achieving the above foregoing objective are as follows:
The present invention provides a display device with a heat exchange module, including the features as contained in claim 1.

The heat exchange module of the present invention is of an integral structure, and is provided with the first heat exchange holes inside the sealed space and the second heat exchange holes outside the sealed space. The first circulation airflow in the sealed space flows through the first heat exchange holes, the second circulation airflow formed by outside air flows through the second heat exchange holes, and further, the second circulation airflow performs heat exchange on the first circulation airflow through the first heat exchange holes and the second heat exchange holes, heat of the first circulation airflow is brought away, and a temperature of the first circulation airflow is lowered. Further, a temperature of the display unit may be lowered through circulation flowing of the first circulation airflow subjected to temperature lowering in the sealed space, and influence on normal use of the display unit caused by too high temperature is avoided. The present invention realizes heat exchange on the first circulation airflow by the second circulation airflow by using the second heat exchange holes and the first heat exchange holes formed in the heat exchange module of the integral structure. Compared with an existing heat dissipation fin, the present invention can improve the heat exchange efficiency to achieve a fast temperature lowering effect, so that a good heat dissipation effect is achieved on the display unit.

The display device with the heat exchange module of the present invention has further improvement that the display unit includes a front portion used for display and a back portion opposite to the front portion; and
the heat exchange module is positioned at the back portion of the display unit.

The display device with the heat exchange module of the present invention has further improvement that a heat exchange plate is arranged between the first heat exchange hole and the second heat exchange hole of the heat exchange module.

The display device with the heat exchange module of the present invention has further improvement that fans are arranged in the sealed space, and through the fans, the first circulation airflow is formed in the sealed space.

The display device with the heat exchange module of the present invention an accommodating space near the sealed space that is further formed inside the casing;
the casing is provided with ventilation openings communicating with outside in a way of corresponding to the accommodating space; and
the second heat exchange holes of the heat exchange modules are disposed inside the accommodating space, and communicate with the outside through the ventilation opening.

The display device with the heat exchange module of the present invention has further improvement that the ventilation openings are formed in a top and a bottom of the casing, ventilation fans are arranged in positions of the ventilation openings positioned in the top, and through the ventilation fans, outside air is blown into the second heat exchange holes to form the second circulation airflow.

The display device with the heat exchange module of the present invention has further improvement that the heat exchange module includes a plurality of heat exchange units, and the plurality of heat exchange units are connected through splicing.

The display device with the heat exchange module of the present invention has further improvement that the heat exchange unit is provided with a first splicing end and a second splicing end which are in opposite arrangement;
a first latching portion is arranged on the first splicing end;
a second latching portion matched with the first latching portion is arranged on the second splicing end; and
the two adjacent heat exchange units realize splicing connection by latching the corresponding first latching portion to the corresponding second latching portion.

The display device with the heat exchange module of the present invention has further improvement that two sealed spaces are formed inside the casing, one display unit is arranged in each sealed space, and the two display units are arranged in a back-to-back mode;
an accommodating space positioned between the two sealed spaces is also formed inside the casing, and the accommodating space communicates with the outside; and
the second heat exchange holes formed in the heat exchange module are positioned inside the accommodating space, and the first heat exchange holes formed in the heat exchange module are formed in two sides of the second heat exchange holes and are positioned in the corresponding sealed spaces.

The present invention further provides a heat exchange method of a display device with a heat exchange module, and the heat exchange method includes the following steps:
providing a casing, forming a sealed space inside the casing, and arranging a display unit of the display device into the sealed space;
installing the heat exchange module on the casing, and forming first heat exchange holes and second heat exchange holes in the heat exchange module;
disposing the first heat exchange holes inside the sealed space, and forming a first circulation airflow between the first heat exchange holes and the sealed space;
disposing the second heat exchange holes outside the sealed space, and communicating the second heat exchange holes with the outside to form a second circulation airflow; and
performing heat exchange on the first circulation airflow through the second circulation airflow.

The heat exchange method of the present invention has further improvement that the heat exchange method further includes:
arranging a heat exchange plate between the first heat exchange holes and the second heat exchange holes of the heat exchange module so as to perform separation and heat exchange.

### BRIEF DESCRIPTION OF THE DRAWINGS

Fig. 1 is a front view of a display device with a heat exchange module of the present invention.
Fig. 2 is an A-A sectional view in Fig. 1.
Fig. 3 is a schematic three-dimensional structure diagram of a cut part of the display device with the heat exchange module of the present invention.
Fig. 4 is a schematic three-dimensional structure diagram of a cut part of another embodiment of the display device with the heat exchange module of the present invention.
Fig. 5 is a sectional view of the embodiment as shown in Fig. 4.
Fig. 6 is a schematic structure diagram of the heat exchange module in the display device with the heat exchange module of the present invention.
Fig. 7 is a sectional view of the heat exchange module of the present invention.
Fig. 8 is schematic structure diagram of another embodiment of the heat exchange module of the present invention.
Fig. 9 is schematic structure diagram of the heat exchange module formed by splicing heat exchange units of the present invention.
Fig. 10 and Fig. 12 are schematic diagrams of detailed steps of a splicing process of two heat exchange units of the present invention.
Fig. 11 is a partial enlarged schematic diagram in a B1 part in Fig. 10.
Fig. 13 is a partial enlarged schematic diagram in a B2 part in Fig. 12.

### DETAILED DESCRIPTION

The present invention is further described below with reference to the accompanying drawings and specific embodiments.

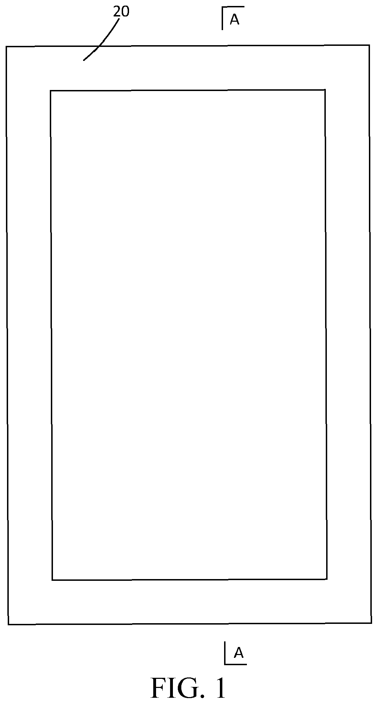

Referring to Fig. 1, the present invention provides a display device with a heat exchange module and a heat exchange method thereof for enhancing a heat dissipation effect of the display device. By using the heat exchange module, first heat exchange holes are formed inside a sealed space for accommodating the display device, second heat exchange holes are formed outside the sealed space, and the second heat exchange holes communicate with the outside, so that a second circulation airflow is formed in the second heat exchange holes, and heat exchange is performed on a first circulation airflow flowing through the first heat exchange holes in the sealed space so as to lower the temperature in the sealed space. The second circulation airflow is used for performing heat exchange with the first circulation airflow, the heat exchange efficiency can be improved, and a fast temperature lowering effect is achieved, so that a better heat dissipation effect is achieved. The display device with the heat exchange module and the heat exchange method thereof of the present invention will be illustrated hereafter with reference to the accompanying drawings.

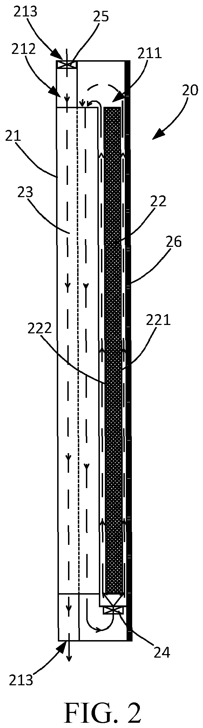

Referring to Fig. 1, it shows a front view of the display device with the heat exchange module of the present invention. Referring to Fig. 2, it shows an A-A sectional view in Fig. 1. The display device with the heat exchange module of the present invention will be illustrated hereafter with reference to Fig. 1 and Fig. 2.

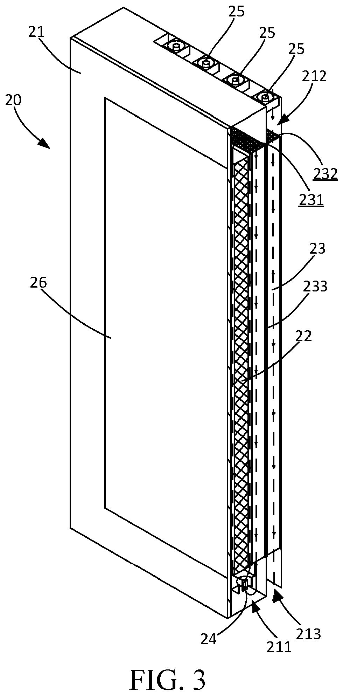

As shown in Fig. 1 and Fig. 2, the display device 20 with the heat exchange module of the present invention includes a casing 21, a display unit 22 and the heat exchange module 23. A sealed space 211 is formed inside the casing 21. The display unit 22 is arranged in the sealed space 211. With reference to Fig. 3, the heat exchange module 23 is provided with first heat exchange holes 231 and second heat exchange holes 232. The first heat exchange holes 231 are positioned in the sealed space 211. A first circulation airflow is formed between the first heat exchange holes 231 and the sealed space 211. The first circulation airflow is used for performing heat dissipation and temperature lowering on the display unit 22 in the sealed space 211. The second heat exchange holes 232 are positioned outside the sealed space 211. The second heat exchange holes 232 communicate with the outside to form a second circulation airflow used for performing heat exchange with the first circulation airflow. The second circulation airflow performs heat exchange with the first circulation airflow for lowering the temperature of the first circulation airflow, and further, after the temperature lowering, the first circulation airflow then performs heat dissipation and temperature lowering on the display unit 22, thus realizing heat dissipation on the display unit.

The second circulation airflow is from outside air, so that the temperature of the second circulation airflow is lower than the temperature of the first circulation airflow in the sealed space, and the second circulation airflow may be called as cold air. The display unit 22 in the sealed space may radiate heat during operation. Moreover, the display device 20 is arranged outdoors, through sunlight irradiation, the temperature in the sealed space is also enabled to rise, so that the temperature of the first circulation airflow in the sealed space is higher, and the first circulation airflow may be called as hot air. The first circulation airflow cyclically flows in the sealed space 211. When flowing through the first heat exchange holes 231, the first circulation airflow performs heat exchange with the second heat circulation airflow flowing through the second heat exchange holes 232. The first heat exchange holes 231 and the second heat exchange holes 232 are all formed in the heat exchange module 23, the heat exchange module 23 is of an integral structure, the heat exchange between the second circulation airflow and the first circulation airflow is realized through a structure body of the heat exchange module 23, that is, the cold air and the hot air perform heat exchange for lowering the temperature of the first circulation airflow in the sealed space, that is, the temperature of the hot air is lowered so that the hot air becomes cold air, and heat of the display unit 22 can be continuously brought away in a circulation process, so that heat dissipation and temperature lowering are performed on the display unit.

In a concrete embodiment of the present invention, as shown in Fig. 2, the display unit 22 includes a front portion 221 used for display and a back portion 222 opposite to the front portion 221. The heat exchange module 23 is positioned at the back portion 222 of the display unit 22. Further, transparent glass 26 is arranged in the position of the front portion 221 of the display unit 22. The transparent glass 26 is arranged on the casing 21. The casing is provided with an opening matched with the display unit 22 in a way of corresponding to the display unit 22, and the transparent glass 26 is arranged in the opening position, so that the transparent glass 26 can protect the display unit 22 without shielding images displayed by the display unit 22.

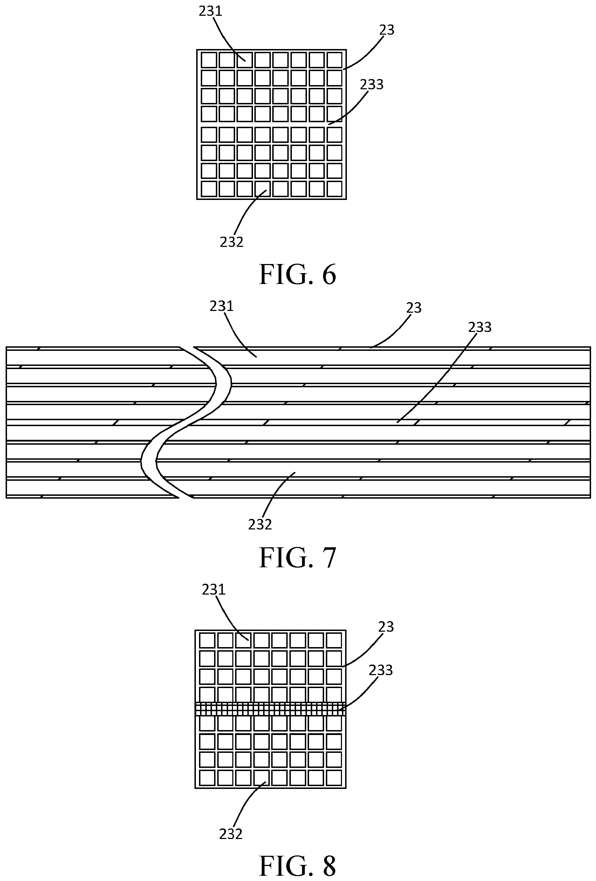

In a concrete embodiment of the present invention, with reference to Fig. 3 and Fig. 6, a heat exchange plate 233 is arranged between the first heat exchange holes 231 and the second heat exchange holes 232 of the heat exchange module 23. The arranged heat exchange plate 233 is used for achieving a heat conduction effect, heat of the first circulation airflow flowing through the first heat exchange holes 231 is conducted to the second circulation airflow flowing through the second heat exchange holes 232, thus improving the heat exchange efficiency between the second circulation airflow and the first circulation airflow, accelerating a temperature lowering speed on the first circulation airflow and improving a temperature lowering and heat dissipation effect on the display unit. Additionally, the heat exchange plate 233 also achieves a separation effect, and the first heat exchange holes 231 and the second heat exchange holes 232 are separated by the heat exchange plate 233. Preferably, the heat exchange plate 233 is made of a material with high heat conduction performance, such as an aluminum material.

Further, when the heat exchange module 23 is arranged on the casing 21, the casing 21 is connected with the heat exchange plate 233 of the heat exchange module 23 in a sealed way so as to ensure sealed performance of the sealed space 211, thus providing a clean and sealed work environment for the display unit 22.

Specifically, an installing opening for installing the heat exchange module 23 is formed in the casing 21. The heat exchange module 23 is clamped into the installing opening. The first heat exchange holes 231 are positioned in the sealed space 211. The second heat exchange holes 232 are positioned outside the sealed space 211 and communicate with the outside. The heat exchange plate 233 is correspondingly positioned in a position of the installing opening. The heat exchange plate 233 is connected with the casing 21 on a peripheral edge of the installing opening in a sealed way. In an exemplary embodiment, a sealant is used for coating between the heat exchange plate 233 and a corresponding part of the casing 21 to realize sealed connection. In another exemplary embodiment, each end portion of the heat exchange plate 233 protrudes outwards to form a connecting end plate. The corresponding portion of the casing 21 forms a clamping portion. The clamping portion tightly clamps the connecting end plate, and a sealing pad is padded between the clamping portion and the connecting end plate, thus realizing sealed connection.

Further, a dimension of the heat exchange module 23 is matched with a dimension of the display unit 22, so that a goal of performing fast temperature lowering and heat dissipation on the display unit 22 can be realized through heat dissipation capability of the heat exchange module 23.

With reference to Fig. 6 and Fig. 7, the first heat exchange holes 231 and the second heat exchange holes 232 formed in the heat exchange module 23 are through holes penetrating through two opposite end sides of the heat exchange module 23. A plurality of first heat exchange holes 231 and a plurality of second heat exchange holes 232 are used so as to improve the heat dissipation effect. Preferably, the first heat exchange holes 231 and the second heat exchange holes 232 are in array arrangement in a transversely and longitudinally aligned mode. Hole wall plates are respectively shared between the adjacent first heat exchange holes 231, between the adjacent second heat exchange holes 232 and the adjacent first heat exchange hole 231 and second heat exchange hole 232. Heat exchange is performed through the shared hole wall plates, heat in the sealed space can be conducted to outside of the sealed space, and is further brought away by the second circulation airflow, and a heat dissipation effect on the display unit is achieved. In an embodiment as shown in Fig. 6 and Fig. 7, the first heat exchange holes 231 and the second heat exchange holes 232 have square cross sections, and are arranged in a length direction of the heat exchange module 23. In the embodiment, the hole wall plates of all the heat exchange holes may be correspondingly connected to form transverse and longitudinal separation plates, the separation plates may also be used as the heat exchange plate, when the separation plates are arranged on the casing 21, a certain separation plate may be selected to be used as the heat exchange plate to be connected with the casing 21 according to heat dissipation requirements, so that heat exchange holes positioned inside the sealed space 211 are the first heat exchange holes, and heat exchange holes positioned outside the sealed space 211 are the second heat exchange holes. Therefore, a goal of automatically regulating a quantity of the heat exchange holes positioned inside and outside the sealed space 211 according to practical requirements can be achieved. Preferably, the heat exchange module 23 is formed through extrusion.

In another exemplary embodiment, the cross section shapes of the first heat exchange holes 231 and the second heat exchange holes 232 may be any shapes, such as round shapes, triangular shapes, hexagonal shapes and other special shapes. The heat exchange plate 233 arranged between the first heat exchange holes 231 and the second heat exchange holes 232 is in flat and straight arrangement, so that sealed connection between the heat exchange plate and the casing 21 is enabled to be met so as to ensure sealed performance of the sealed space 211.

In a concrete embodiment of the present invention, as shown in Fig. 8, in order to improve the heat exchange effect of the first circulation airflow and the second circulation airflow, a width of the heat exchange plate 233 on the heat exchange module 23 is greater than a width of the hole wall plate of the heat exchange holes except for the heat exchange holes in the position of the heat exchange plate 233 so as to achieve a goal of increasing heat capacity in a heat exchange position by increasing a cross section area in a separation part, so that the heat exchange effect between the first heat exchange holes and the second heat exchange holes positioned at two sides of the heat exchange plate 233 is good, and the heat exchange efficiency is further improved.

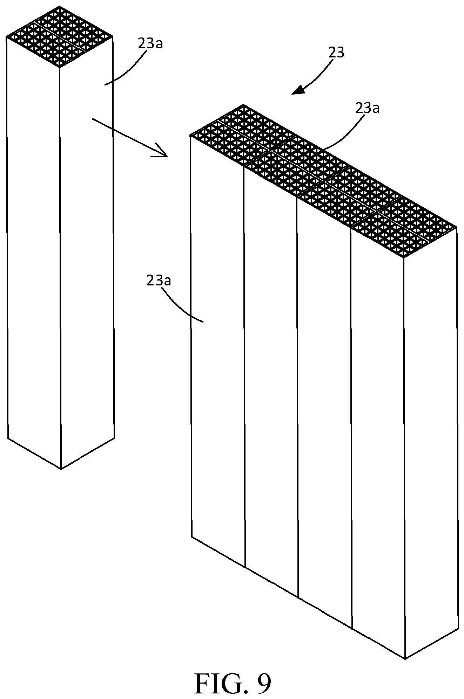

In a concrete embodiment of the present invention, as shown in Fig. 9, the heat exchange module 23 includes a plurality of heat exchange units 23a, and the plurality of heat exchange units 23a are connected through splicing to form the heat exchange module 23. Through formation of the heat exchange module 23 by splicing the plurality of heat exchange units 23a, the quantity of the heat exchange units 23a may be selected according to dimension matching of the used display device 20, and a stacking combination use effect according to practical requirements is achieved.

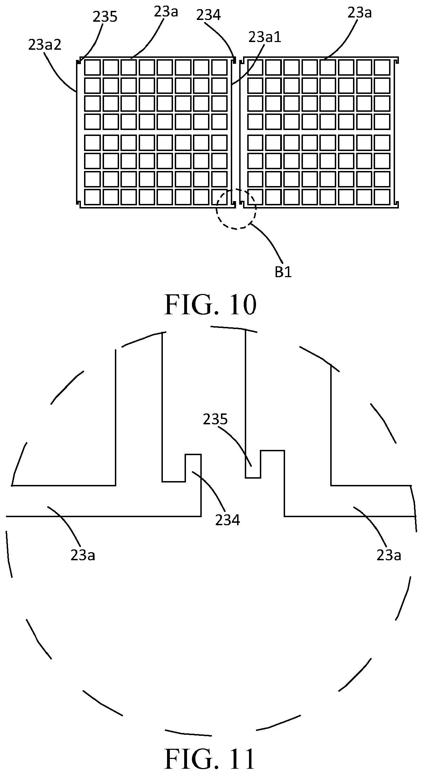

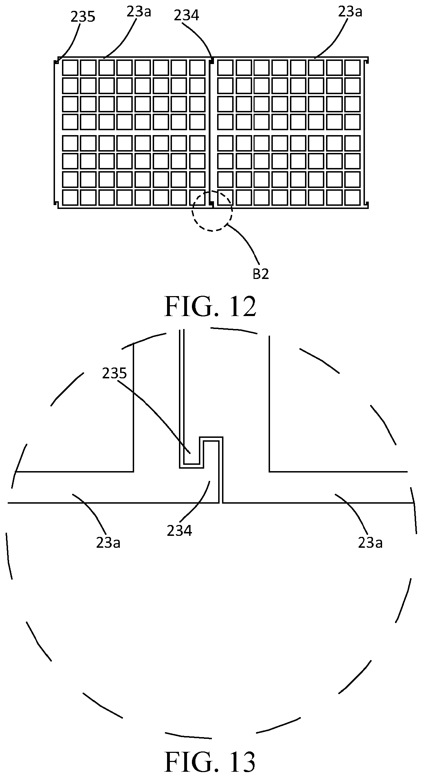

Further, with reference to Fig. 10 and Fig. 12, the heat exchange unit 23a is provided with a first splicing end 23a1 and a second splicing end 23a2 which are in opposite arrangement. A first latching portion 234 is arranged on the first splicing end 23a1. A second latching portion 235 is arranged on the second splicing end 23a2. The second latching portion 235 and the first latching portion 234 are matched with each other and can be in mutual latching connection. When the two heat exchange units 23a are spliced, the first latching portion 234 of one heat exchange unit 23a is latched onto the second latching portion 235 of the other heat exchange unit 23a, so that the splicing connection between the two heat exchange units 23a is realized.

Specifically, with reference to Fig. 11 and Fig. 13, the first latching portion 234 is L-shaped buckles formed at two sides of an end surface of the first splicing end 23a 1 of the heat exchange unit 23a. The two L-shaped buckles are in opposite arrangement. A latching groove is formed between each L-shaped buckle and an end surface of the first splicing end 23a1. The second latching portion 235 is an extending plate formed on an end surface of the second splicing end 23a2 of the heat exchange unit 23a and convex strips formed at two end sides of the extending plate. A dimension of the extending plate is matched with the L-shaped buckles. The convex strips are matched with the latching grooves. When the two adjacent heat exchange units 23a are mutually spliced, the two convex strips of one heat exchange unit 23a are latched into the two latching grooves of the other heat exchange unit 23a, and the extending plate is positioned between the two L-shaped buckles, so that splicing of the two heat exchange units 23a is realized.

In a concrete embodiment of the present invention, as shown in Fig. 2 and Fig. 3, fans 24 are arranged in the sealed space 211, and through the fans 24, the first circulation airflow is formed in the sealed space 211. Due to the sealed performance of the inside of the sealed space 211, the fans 24 are arranged in the sealed space 211, and the first circulation airflow may be formed inside the sealed space 211 through operation of the fans 24. Preferably, the fans 24 are arranged on the casing 21, specifically, an installing plate may be connected to the inner wall of the casing 21, and the fans 24 are fixed on the installing plate. Further, the fans 24 may be positioned at the bottom of the display unit 22, and are used for blowing air to the bottom of the display unit 22, so that a flowing direction of the formed first circulation airflow is from bottom to top of the display unit 22. After reaching the top of the display unit 22, the first circulation airflow may further flow into the first heat exchange holes 231, flows to the bottom from the top of the first heat exchange holes 231, and is further blown to the display unit 22 again by the fans 24, thus forming the first circulation airflow flowing in an anticlockwise circulation mode. The first circulation airflow can blow away heat at the front portion and the back portion of the display unit 22, and further performs heat exchange with the second circulation airflow in the second heat exchange holes 232 when flowing through the first heat exchange holes 231 to realize temperature lowering and heat dissipation, circulation is repeatedly performed in such a way, and a better heat dissipation effect can be realized.

In a concrete embodiment of the present invention, an accommodating space 212 near the sealed space 211 is also formed inside the casing 21. The casing 21 is provided with ventilation openings 213 communicating with the outside in a way of corresponding to the accommodating space 212. The second heat exchange holes 232 of the heat exchange module 23 are disposed inside the accommodating space 212, and communicate with the outside through the ventilation openings 213.

Preferably, the ventilation openings 213 are formed in a top and a bottom of the casing 21, ventilation fans 25 are arranged in positions of the ventilation openings 213 positioned in the top, and through the ventilation fans 25, outside air is blown into the second heat exchange holes 232 to form the second circulation airflow. The flowing direction of the second circulation airflow is from the top to the bottom of the second heat exchange holes 232, and is identical to the flowing direction of the first circulation airflow in the first heat exchange holes 231. Outside cold air is continuously blown into the second heat exchange holes 232 through the ventilation fans 25. The cold air entering the second heat exchange holes 232 performs heat exchange with the first circulation airflow through the hole wall plates of all the heat exchange holes and the heat exchange plate. The heat in the sealed space is brought away, and is further discharged from the ventilation openings 213 formed in the bottom. Circulation is repeatedly performed in such a way, a goal of continuously performing heat dissipation on the first circulation airflow in the sealed space is achieved, and a heat dissipation effect on the display device is further realized.

In a concrete embodiment of the present invention, the casing 21 includes a front casing plate, a back casing plate and four side casing plates. The front casing plate and the back casing plate are in opposite arrangement. The four side casing plates are sequentially connected in a butt joint manner to form a square frame and are connected with the front casing plate and the back casing plate in a sealed way. An opening is formed in the front casing plate. Transparent glass 26 is connected to the opening position in a sealed way. Connecting plates connected with the heat exchange module in a sealed way are arranged inside the four side casing plates. The connecting plates are connected in a sealed way with the heat exchange plate arranged on the heat exchange module.

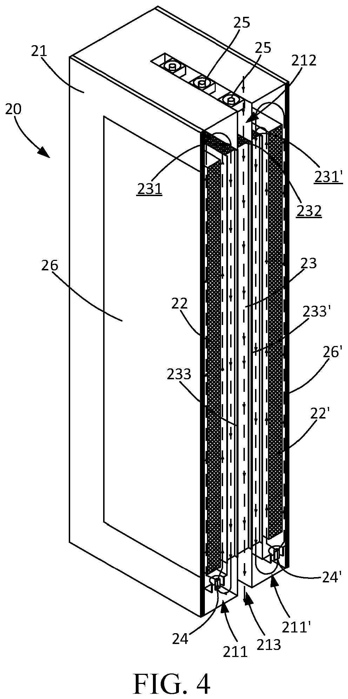

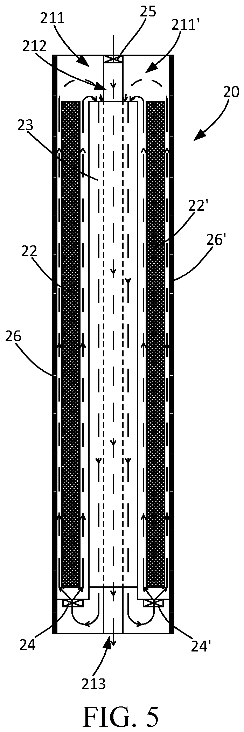

In a concrete embodiment of the present invention, as shown in Fig. 4 and Fig. 5, in the embodiment, the display device 20 of the present invention is a double-sided display device. Two sealed spaces 211 are formed inside the casing 21, one is the sealed space 211, and the other one is a sealed space 211'. One display unit 22, 22' is arranged in each sealed space 211, 211'. The display unit 22 and the display unit 22' are arranged in a back-to-back mode, and one side used for display faces outward. An accommodating space 212 positioned between the two sealed spaces 211 and 211' is also formed inside the casing 21. The accommodating space 212 communicates with the outside. The second heat exchange holes 232 formed in the heat exchange module 23 are positioned inside the accommodating space 212. The first heat exchange holes 231 and 231' formed in the heat exchange module 23 are formed in two sides of the second heat exchange holes 232 and are positioned in the corresponding sealed spaces 211 and 211'.

Two heat exchange plates, i.e. a heat exchange plate 233 and a heat exchange plate 233' are formed on the heat exchange module 23. The heat exchange plate 233 and the heat exchange plate 233' are connected with the casing in a sealed way to further form the sealed space 211 and the sealed space 211' in the casing. The first heat exchange holes 231 in one side of the heat exchange plate 233 are disposed inside the sealed space 211. The first heat exchange holes 231' in one side of the heat exchange plate 233' are disposed inside the sealed space 211'. The second heat exchange holes 232 between the heat exchange plate 233 and the heat exchange plate 233' are disposed inside the accommodating space 212.

A second circulation airflow is formed inside the second heat exchange holes 232 of the heat exchange module 23. The second circulation airflow may perform heat dissipation on the first circulation airflow flowing through the inside of the first heat exchange holes 231 and 231', thus realizing heat dissipation on the two display units 22 and 22'.

Preferably, ventilation openings are formed in a top and a bottom of the casing in a way of corresponding to the accommodating space 212. The ventilation openings in the top are provided with ventilation fans 25. The ventilation fans 25 are used for forming a second circulation airflow inside the second heat exchange holes 232. Fans 24 are arranged in the sealed space 211. Fans 24' are arranged in the sealed space 211'. A first circulation airflow is formed inside the sealed space 211 by using the fans 24. The formed first circulation airflow flows through the first heat exchange holes 231 to perform heat exchange with the second circulation airflow to realize heat dissipation. A first circulation airflow is formed in the sealed space 211' by using the fans 24'. The formed first circulation airflow flows through the first heat exchange holes 231' to perform heat exchange with the second circulation airflow to realize heat dissipation.

The present invention further provides a heat exchange method of a display device with a heat exchange module, and a heat exchange method is illustrated hereafter.

The heat exchange method of the display device with the heat exchange module of the present invention includes the following steps:
as shown in Fig. 2 and Fig. 3, providing a casing 21, forming a sealed space 211 inside the casing 21, and arranging a display unit 22 of the display device 20 into the sealed space 211;
installing the heat exchange module 23 on the casing 21, and forming first heat exchange holes 231 and second heat exchange holes 232 in the heat exchange module 23;
disposing the first heat exchange holes 231 inside the sealed space 211, and forming a first circulation airflow between the first heat exchange holes 231 and the sealed space 211;
disposing the second heat exchange holes 232 outside the sealed space 211, and communicating the second heat exchange holes 232 with the outside to form a second circulation airflow; and
performing heat exchange on the first circulation airflow through the second circulation airflow.

The first heat exchange holes and the second heat exchange holes are formed in an integral structure of the heat exchange module. The heat exchange module is partially arranged inside the sealed space, and partially arranged outside the sealed space. The first circulation airflow flows through the inside of the first heat exchange holes inside the sealed space. The first circulation airflow can transmit heat generated by operation of the display unit 22 and heat formed through sun irradiation to the second circulation airflow inside the second heat exchange holes through the heat exchange module so realize the heat exchange on the first circulation airflow by the second circulation airflow. Additionally, the second circulation airflow is from outside cold air, and can continuously perform heat exchange on the first circulation airflow to perform heat dissipation on the first circulation airflow, so that the heat dissipation on the display device is also realized.

In a concrete embodiment of the present invention, the heat exchange method further includes:
arranging a heat exchange plate 233 between the first heat exchange holes 231 and the second heat exchange holes 232 of the heat exchange module 23 so as to perform separation and heat exchange.

The heat exchange plate is used for achieving separation and heat conduction effects, and the first heat exchange holes and the second heat exchange holes can be separated by the heat exchange plate, so that the first heat exchange holes and the second heat exchange holes are respectively disposed inside and outside the sealed space. The heat exchange plate also achieves a heat conduction effect between the first heat exchange holes and the second heat exchange holes, and the heat of the first circulation airflow can be transmitted to the second circulation airflow, so that temperature lowering and heat dissipation are performed on the first circulation airflow, and the temperature lowering and heat dissipation on the display unit are realized through the first circulation airflow.

The present invention is described above in detail with reference to the embodiments of the accompanying drawings, and a person of ordinary skill in the art may make various modifications to the present invention according to the above description. Therefore, some details in the embodiments shall not constitute a limitation on the present invention, and the protection scope of the present invention shall be subject to the scope of the appended claims.

## Claims

1. A display device (20) with a heat exchange module (23), having:
a casing (21) with a sealed space (211) formed inside, and
a display unit (22) arranged in the sealed space (211);
the heat exchange module (23) arranged within
the casing (21), wherein the heat exchange module (23) is provided with:
first heat exchange holes (231) positioned inside the sealed space (211), wherein a first circulation airflow is formed between the first heat exchange holes (231) and the sealed space (211); and
second heat exchange holes (232) positioned outside the sealed space (211), wherein the second heat exchange holes (232) communicate with the outside to form a second circulation airflow for performing heat exchange with the first circulation airflow,
wherein, an accommodating space (212) adjacent the sealed space (211) is further formed inside the casing (21);
the casing (21) is provided with ventilation openings (213) communicating with the outside pleading to the accommodating space (212); and
the second heat exchange holes (232) of the heat exchange module (23) are disposed inside the accommodating space (212), and communicate with the outside through the ventilation openings (213).

2. The display device (20) with the heat exchange module (23) according to claim 1, wherein
the display unit (22) comprises a front portion (221) used for display and a back portion (222) opposite to the front portion (221); and
the heat exchange module (23) is positioned at the back portion (222) of the display unit (22).

3. The display device (20) with the heat exchange module (23) according to claim 1, wherein
a heat exchange plate (233) is arranged between the first heat exchange holes (231) and the second heat exchange holes (232) of the heat exchange module (23).

4. The display device (20) with the heat exchange module (23) according to claim 3, wherein
fans (24) are arranged in the sealed space (211), and through the fans (24), the first circulation airflow is formed in the sealed space (211).

5. The display device (20) with the heat exchange module (23) according to claim 1, wherein
the ventilation openings (213) are formed in a top and a bottom of the casing (21), ventilation fans (25) are arranged in positions of the ventilation openings (213) positioned in the top, and through the ventilation fans (25),
outside air is blown into the second heat exchange holes (232) to form the second circulation airflow.

6. The display device (20) with the heat exchange module (23) according to claim 1, wherein
two sealed spaces (211) are formed inside the casing (21), one display unit (22) is arranged in each sealed space (211, 211'), and the two display units (22) are arranged in a back-to-back mode;
the accommodating space (212) positioned between the two sealed spaces (211) is also formed inside the casing (21), and the accommodating space (212) communicates with the outside; and
the second heat exchange holes (232) formed in the heat exchange module (23) are positioned inside the accommodating space, and the first heat exchange holes (231) formed in the heat exchange module (23) are formed in two sides of the second heat exchange holes (232) and are positioned in the corresponding sealed spaces (211, 211').

## Patentansprüche

1. Anzeigevorrichtung (20) mit einem Wärmeaustauschmodul (23), aufweisend:
ein Gehäuse (21), in dem ein abgedichteter Raum (211) ausgebildet ist, und
eine Anzeigeeinheit (22), die in dem abgedichteten Raum (211) angeordnet ist;
wobei das Wärmeaustauschmodul (23) in dem Gehäuse (21) angeordnet ist, wobei das Wärmeaustauschmodul (23) Folgendes aufweist:
erste Wärmeaustauschlöcher (231), die innerhalb des abgedichteten Raums (211) angeordnet sind, wobei ein erster zirkulierender Luftstrom zwischen den ersten Wärmeaustauschlöchern (231) und dem abgedichteten Raum (211) gebildet wird; und
zweite Wärmeaustauschlöcher (232), die außerhalb des abgedichteten Raums (211) angeordnet sind, wobei die zweiten Wärmeaustauschlöcher (232) mit der Außenseite verbunden sind, um einen zweiten zirkulierenden Luftstrom zum Wärmeaustausch mit dem ersten zirkulierenden Luftstrom zu bilden,
wobei
innerhalb des Gehäuses (21) ferner ein Aufnahmeraum (212), der an den abgedichteten Raum (211) angrenzt, ausgebildet ist;
wobei das Gehäuse (21) mit Entlüftungsöffnungen (213) versehen ist, die mit der Außenseite verbunden sind und zu dem Aufnahmeraum (212) führen; und
wobei die zweiten Wärmeaustauschlöcher (232) des Wärmeaustauschmoduls (23) innerhalb des Aufnahmeraums (212) angeordnet und über die Entlüftungsöffnungen (213) mit der Außenseite verbunden sind.

2. Anzeigevorrichtung (20) mit dem Wärmeaustauschmodul (23) nach Anspruch 1, wobei
die Anzeigeeinheit (22) einen zum Anzeigen dienenden Vorderabschnitt (221) und einen dem Vorderabschnitt (221) gegenüberliegenden Hinterabschnitt (222) umfasst; und
wobei das Wärmeaustauschmodul (23) an dem Hinterabschnitt (222) der Anzeigeeinheit (22) positioniert ist.

3. Anzeigevorrichtung (20) mit dem Wärmeaustauschmodul (23) nach Anspruch 1, wobei eine Wärmeaustauschplatte (233) zwischen den ersten Wärmeaustauschlöchern (231) und den zweiten Wärmeaustauschlöchern (232) des Wärmeaustauschmoduls (23) angeordnet ist.

4. Anzeigevorrichtung (20) mit dem Wärmeaustauschmodul (23) nach Anspruch 3, wobei
Gebläse (24) in dem abgedichteten Raum (211) angeordnet sind und über die Gebläse (24) der erste zirkulierende Luftstrom in dem abgedichteten Raum (211) gebildet.

5. Anzeigevorrichtung (20) mit dem Wärmeaustauschmodul (23) nach Anspruch 1, wobei die Entlüftungsöffnungen (213) in einer Oberseite und einer Unterseite des Gehäuses (21) ausgebildet sind, wobei Lüftungsgebläse (25) an Positionen der in der Oberseite positionierten Entlüftungsöffnungen (213) angeordnet sind, wobei durch die Lüftungsgebläse (25) Außenluft in die zweiten Wärmeaustauschlöcher (232) geblasen wird, um den zweiten zirkulierenden Luftstrom zu bilden.

6. Anzeigevorrichtung (20) mit dem Wärmeaustauschmodul (23) nach Anspruch 1, wobei
zwei abgedichtete Räume (211) innerhalb des Gehäuses (21) ausgebildet sind, wobei eine Anzeigeeinheit (22) in jedem Abgedichteten Raum (211, 211') angeordnet ist, und wobei die zwei Anzeigeeinheiten (22) Rücken an Rücken angeordnet sind;
wobei der Aufnahmeraum (212), der zwischen den zwei abgedichteten Räumen (211) angeordnet ist, ferner innerhalb des Gehäuses (21) ausgebildet ist, und wobei der Aufnahmeraum (212) ist mit der Außenseite verbunden ist; und
wobei die zweiten Wärmeaustauschlöcher (232), die in dem Wärmeaustauschmodul (23) ausgebildet sind, in dem Aufnahmeraum positioniert sind, und wobei die ersten Wärmeaustauschlöcher (231), die in dem Wärmeaustauschmodul (23) ausgebildet sind, in zwei Seiten der zweiten Wärmeaustauschlöcher (232) ausgebildet und in den entsprechenden abgedichteten Räumern (211, 211') positioniert sind.

## Revendications

1. Un dispositif d'affichage (20) avec un module d'échange de chaleur (23), muni de :
un boîtier (21) avec un espace hermétique (211) formé à l'intérieur, et
une unité d'affichage (22) agencée dans l'espace hermétique (211) ;
le module d'échange de chaleur (23) agencé dans le boîtier (21), dans lequel le module d'échange de chaleur (23) est muni de :
premiers trous d'échange de chaleur (231) positionnés à l'intérieur de l'espace hermétique (211), dans lequel un premier flux d'air de circulation est formé entre les premiers trous d'échange de chaleur (231) et l'espace hermétique (211) ; et
deuxièmes trous d'échange de chaleur (232) positionnés à l'extérieur de l'espace hermétique (211), dans lequel les deuxièmes trous d'échange de chaleur (232) communiquent avec l'extérieur pour former un deuxième flux d'air de circulation afin de réaliser l'échange de chaleur avec le premier flux d'air de circulation,
dans lequel,
un espace de logement (212) adjacent de l'espace hermétique (211) est en outre formé à l'intérieur du boîtier (21) ;
le boîtier (21) est muni d'ouvertures de ventilation (213) communiquant avec l'extérieur menant à l'espace de logement (212) ; et
les deuxièmes trous d'échange de chaleur (232) du module d'échange de chaleur (23) sont placés à l'intérieur de l'espace de logement (212), et communiquent avec l'extérieur via les ouvertures de ventilation (213).

2. Un dispositif d'affichage (20) avec un module d'échange de chaleur (23) selon la revendication 1, dans lequel
l'unité d'affichage (22) comprend une partie avant (221) servant à l'affichage et une partie arrière (222) opposée à la partie avant (221) ; et
le module d'échange de chaleur (23) est positionné à la partie arrière (222) de l'unité d'affichage (22).

3. Un dispositif d'affichage (20) avec un module d'échange de chaleur (23) selon la revendication 1, dans lequel
une plaque d'échange de chaleur (233) est agencée entre les premiers trous d'échange de chaleur (231) et les deuxièmes trous d'échange de chaleur (232) du module d'échange de chaleur (23).

4. Un dispositif d'affichage (20) avec un module d'échange de chaleur (23) selon la revendication 3, dans lequel
des ventilateurs (24) sont agencés dans l'espace hermétique (211), et à travers les ventilateurs (24) le premier flux d'air de circulation est formé dans l'espace hermétique (211).

5. Un dispositif d'affichage (20) avec un module d'échange de chaleur (23) selon la revendication 1, dans lequel
les ouvertures de ventilation (213) sont formées au sommet et au fond du boîtier (21), des ventilateurs(25) sont agencés aux positions des ouvertures de ventilation (213) positionnées au sommet, et à travers les ventilateurs (25),
l'air extérieur est soufflé dans les deuxièmes trous d'échange de chaleur (232) pour former le deuxième flux d'air de circulation.

6. Un dispositif d'affichage (20) avec un module d'échange de chaleur (23) selon la revendication 1, dans lequel
deux espaces hermétiques (211) sont formés à l'intérieur du boîtier (21), une unité d'affichage (22) est agencée dans chaque espace hermétique (211, 211'), et les deux unités d'affichage (22) sont agencées dos-à-dos ;
l'espace de logement (212) positionné entre les deux espaces hermétiques (211) est également formé à l'intérieur du boîtier (21), et l'espace de logement (212) communique avec l'extérieur ; et
les deuxièmes trous d'échange de chaleur (232) formés dans le module d'échange de chaleur (23) sont positionnés à l'intérieur de l'espace de logement, et les premiers trous d'échange de chaleur (231) formés dans le module d'échange de chaleur (23) sont formés sur deux côtés les deuxièmes trous d'échange de chaleur (232) et sont positionnés dans les espaces hermétiques correspondants (211, 211').
